# EUROPEAN PATENT SPECIFICATION

(11) **EP 3 982 541 B1**
(45) Date of publication and mention of the grant of the patent: **31.07.2024**
(21) Application number: 21185658.8
(22) Date of filing: 14.07.2021
(51) Int. Cl.: H03K 17/66, G08B 3/10, G10K 1/062, H03K 17/74, H03K 17/795

(54) **DOOR CHIME CONTROL CIRCUIT**
TÜRKLINGELSTEUERSCHALTUNG
CIRCUIT DE COMMANDE DE SONNERIE DE PORTE

(30) Priority: 08.10.2020 TW 109134959
(43) Date of publication of application: 13.04.2022
(73) Proprietor: Pegatron Corporation, Taipei City 112 (TW)
(72) Inventor: FAN CHIANG, Chao-Tung, Taipei City (TW); ZHOU, Zheng-Ting, Taipei City (TW)
(74) Representative: Zimmermann, Tankred Klaus

(56) References cited:
- EP-A1- 3 404 650
- US-A1- 2013 002 336
- US-A1- 2018 308 323

## Description

### BACKGROUND

### Technical Field

The present invention relates to a door chime control circuit, and in particular, to a door chime control circuit that can be connected to door chimes of different types.

### Related Art

In the related art, a door chime may make a ringing sound by using a mechanical chime or a digital chime. After a user presses a button switch, the mechanical chime generates an electromotive force through a coil, which causes a striker to strike a metal piece to produce a single-tone ringing sound.

Patent Application EP 3 404 650 A1 of LG INNOTEK teaches a doorbell device and method for supplying power thereto. However, a disadvantage of this invention is that it requires a mechanical doorbell switch to activate the doorbell.

Patent Application US 2018/308323 A1 of LEE JIN KUK teaches a doorbell apparatus and method of controlling power supply of the same. Similar to other prior art, this invention requires a mechanical doorbell switch to activate the doorbell.

In contrast to the mechanical chime, the digital chime is applicable to a low-voltage alternating current (AC) power supply system. One of phases of a sine wave of an AC is supplied as a power supply to the digital chime, and the other of the phases is used as a trigger signal to trigger the digital chime, so that the digital chime can make a long ringing sound. Typically, during connecting the button switch to the digital chime, a diode is connected in parallel with the button switch. In this case, when the button switch is turned off, the AC power supply is rectified through the diode, and only one phase is supplied to the digital chime as the power supply. When the button switch is turned on, the AC power supply provides a two-phase power supply to the digital chime through the button switch that has been turned on, so as to trigger the digital chime to make the ringing sound. In practice, considering that the digital chime may have different circuit characteristics, two diodes in opposite directions are connected in parallel to the button switch, and a mechanical toggle switch is adopted to connect the digital chime in parallel with one of the two diodes.

### SUMMARY

The present disclosure provides a door chime control circuit, which does not require a mechanical toggle switch but can perform switching between diodes through a control signal.

A door chime control circuit according to the present disclosure is defined in independent claim 1.

Further preferred embodiments are defined in the dependent claims.

### BRIEF DESCRIPTION OF THE DRAWINGS

FIGURE is a schematic diagram showing a door chime control circuit according to an embodiment of the present invention.

### DETAILED DESCRIPTION

Referring to FIGURE, a door chime control circuit 7 according to an embodiment of the present disclosure includes five connection terminals, that is, a first terminal 701, a second terminal 702, a first switching terminal 703, a second switching terminal 704, and a door chime enable terminal 705. The first terminal 701 is configured to be connected to a power supply, such as an 8-24 V AC power supply converted from a 110 V AC of a mains supply 2 through a transformer 3. The second terminal 702 is to be connected to a door chime, which may be a mechanical chime 5 or a digital chime 6.

The first switching terminal 703 is configured to receive a first switching voltage, and the second switching terminal 704 is configured to receive a second switching voltage. In this embodiment, the first switching voltage is used to enable a first rectifying element 706, and the second switching voltage is used to enable a second rectifying element 707. In this embodiment, the first rectifying element 706 and the second rectifying element 707 are diodes. Details are described later. The door chime enable terminal 705 is configured to receive a door chime enable voltage to trigger the mechanical chime 5 or the digital chime 6 to which the second terminal 702 is connected. The first switching voltage, the second switching voltage, and the door chime enable voltage may be a 3.3 V voltage from another door chime control system, but the present disclosure is not limited to 3.3 V. In this way, by virtue of the door chime control circuit 7, triggering of the door chime, directions of the diodes connected in parallel, and whether to connect the diodes in parallel may be controlled through a control signal (that is, the first switching voltage, the second switching voltage, and the door chime enable voltage) from another door chime control system. In this embodiment, the another door chime control system may be a system related to the door chime control circuit 7, such as an Internet of Things (IoT) control device.

The door chime control circuit 7 include the following elements: a first rectifying element 706, a second rectifying element 707, a first switch 708, a second switch 709, a first isolating element 710, a second isolating element 711, a third switch 712, a fourth switch 713, a fifth switch 716, a sixth switch 717, a first resistor 714, a second resistor 715, a third resistor 718, and a fourth resistor 719. In this embodiment, the first isolating element 710 and the second isolating element 711 are optical couplers.

In the above elements, the first rectifying element 706 is electrically connected to the first terminal 701 and the second terminal 702. The second rectifying element 707 is also electrically connected to the first terminal 701 and the second terminal 702, is connected in parallel to the first rectifying element 706, and has a polarity opposite to that of the first rectifying element 706. In other words, if the first rectifying element 706 is connected to the first terminal 701 with an anode, the second rectifying element 707 is connected to the first terminal 701 with a cathode. In this embodiment, functions of the first rectifying element 706 and the second rectifying element 707 are equivalent to those of the two diodes in opposite directions in the related art, which are not described herein again for brevity.

The first switch 708 is connected in series with the first rectifying element 706, and the second switch 709 is connected in series with the second rectifying element 707. Turning on the first switch 708 can enable the first rectifying element 706, and turning on the first switch 709 can enable the second rectifying element 707. In this embodiment, the first switch 708 and the second switch 709 each are a bipolar junction transistor (BJT) switch. As a gate of the switch, a base of the first switch 708 is connected to an output terminal of the first isolating element 710, and a base of the second switch 709 is connected to an output terminal of the second isolating element 711. In other words, the first switch 708 and the second switch 709 are respectively controlled by the first isolating element 710 and the second isolating element 711 to be turned on or off. In this example, since the bipolar junction transistor switch has a larger response speed than a general switch, operation efficiency of the door chime control circuit can be improved.

An input terminal of the first isolating element 710 is connected to a 3.3 V voltage source, and the other input terminal is electrically connected to a ground terminal through the third switch 712 and the fourth switch 713. In other words, by turning on one of the third switch 712 and the fourth switch 713, a voltage difference of 3.3 V is generated between the two input terminals of the first isolating element 710, thereby turning on two output terminals of the first isolating element 710. The two output terminals of the first isolating element 710 are electrically connected to a gate of the first switch 708 (that is, the base of the bipolar junction transistor switch) and the first terminal 701 respectively. Similarly, an input terminal of the second isolating element 711 is connected to a 3.3 V voltage source, and the other input terminal is electrically connected to the ground terminal through the fifth switch 716 and the sixth switch 717. In other words, by turning on one of the fifth switch 716 and the sixth switch 717, a voltage difference of 3.3 Vis generated between the two input terminals of the second isolating element 711, thereby turning on two output terminals of the second isolating element 711. The two output terminals of the second isolating element 711 are electrically connected to a gate of the second switch 709 (that is, the base of the bipolar junction transistor switch) and the second terminal 702 respectively.

Gates of the third switch 712 and the fifth switch 716 are both electrically connected to the door chime enable terminal 705. A gate of the fourth switch 713 is electrically connected to the first switching terminal 703, and a gate of the sixth switch 717 is electrically connected to the second switching terminal 704. In this embodiment, the third switch 712, the fourth switch 713, the fifth switch 716, and the sixth switch 717 each are a metal oxide semiconductor field effect transistor (MOSFET) switch.

By virtue of the above configuration, the door chime enable voltage may be used to turn on both the third switch 712 and the fifth switch 716, which generates a voltage difference of 3.3 V between the input terminals of the first isolating element 710 and between the input terminals of the second isolating element 711, so that the output terminals of the both first isolating element 710 and the second isolating element 711 are turned on and the gates of the first switch 708 and the second switch 709 are connected to a voltage of the first terminal 701 or the second terminal 702. In this way, both the first switch 708 and the second switch 709 are turned on, and both the first rectifying element 706 and the second rectifying element 707 function, so that an 8-24 V AC power supply received by the first terminal 701 can be transferred to the second terminal 702 to enable the door chime.

The first switching voltage may be used to turn on the fourth switch 713, which generates a voltage difference of 3.3 V between the input terminals of the first isolating element 710, so that the output terminals of the first isolating element are turned on and the gate of the first switch 708 is connected to the second terminal 702. In this way, the first switch 708 is turned on, and the first rectifying element 706 functions to supply one of phases of the AC power supply to the door chime as a power supply. The second switching voltage may be used to turn on the sixth switch 717, which generates a voltage difference of 3.3 V between the input terminals of the second isolating element 711, so that the output terminals of the second isolating element 711 are turned on and the gate of the second switch 709 is connected to the first terminal 701. In this way, the second switch 709 is turned on, and the second rectifying element 707 functions to supply the other of the phases of the AC power supply to the door chime as a power supply. In other words, the first switching voltage and the second switching voltage may be used to selectively enable the first rectifying element 706 or the second rectifying element 707. This replaces a function of a mechanical toggle switch in the conventional technology.

In an example, a plurality of resistors may be disposed in the door chime control circuit 7 to adjust a current that is generated. For example, the first resistor 714 may be connected in series between the third switch 712 and the input terminal of the first isolating element 710 that is electrically connected to the ground terminal, the second resistor 715 may be connected in series between the fourth switch 713 and the input terminal of the first isolating element 710 that is electrically connected to the ground terminal, and the first resistor 714 and the second resistor 715 are connected in parallel with each other. The third resistor 718 may be connected in series between the fifth switch 716 and the input terminal of the second isolating element 711 that is electrically connected to the ground terminal, the fourth resistor 719 may be connected in series between the sixth switch 717 and the input terminal of the second isolating element 711 that is electrically connected to the ground terminal, and the third resistor 718 and the fourth resistor 719 are connected in parallel with each other. A resistance value of the first resistor 714 and a resistance value of the third resistor 718 may be respectively less than a resistance value of the second resistor 715 and a resistance value of the fourth resistor 719.

By virtue of the above configuration of the resistors and selection of the resistance values, a current generated when the third switch 712 is turned on is greater than a current generated when the fourth switch 713 is turned on, and a current generated when the fifth switch 716 is turned on is greater than a current generated when the sixth switch 717 is turned on. Since the isolating element has a characteristic that an amount of a current at the output terminal is positively correlated with an amount of a current at the input terminal, such a design can generate a relatively large driving current to drive the mechanical chime.

By virtue of the above design, if the second terminal 702 of the door chime control circuit 7 is connected to the mechanical chime 5, the first switching terminal 703 and the second switching terminal 704 may skip receiving the first switching voltage and the second switching voltage. In order to enable the mechanical chime 5, the door chime enable voltage may be received through the door chime enable terminal 705 to trigger the mechanical chime 5 to which the second terminal 702 is connected. If the second terminal 702 of the door chime control circuit 7 is connected to the digital chime 6, the first switching voltage or the second switching voltage may be received through one of the first switching terminal 703 and the second switching terminal 704 according to a design of the digital chime 6, to selectively enable the first rectifying element or the second rectifying element having a different rectification direction to supply power of one of the phases of the AC power supply to the digital chime 6. In order to enable the digital chime 6, the door chime enable voltage may be received through the door chime enable terminal 705 to enable the digital chime 6.

The door chime control circuit disclosed above does not require a mechanical toggle switch, and switching between the diodes connected in parallel may be performed through a control signal. Therefore, control of the door chime is more convenient.

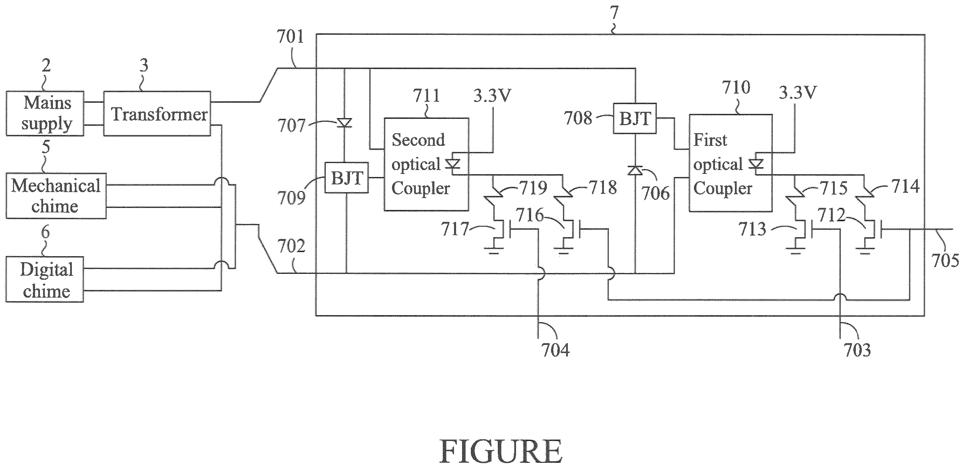

## Claims

1. A door chime control circuit (7) configured to be connected between a power supply and a door chime, comprising:
a first terminal (701) configured to be connected to the power supply; a second terminal (702) configured to be connected to the door chime;
a first switching terminal (703) configured to receive a first switching voltage;
a second switching terminal (704) configured to receive a second switching voltage;
a door chime enable terminal (705) configured to receive a door chime enable voltage;
a first rectifying element (706) electrically connected to the second terminal (702);
a second rectifying element (707) electrically connected to the first terminal (701);
a first switch (708) connected between the first terminal (701) and the first rectifying element (706) and in series with the first rectifying element (706), wherein the first switching voltage is used to turn on the first switch (708) to enable the first rectifying element (706);
a second switch (709) connected between the second terminal (702) and the second rectifying element (707) and in series with the second rectifying element (707), wherein the second switching voltage is used to turn on the second switch (709) to enable the second rectifying element (707);
wherein the second rectifying element (707) and the second switch (709) are connected in parallel with the first rectifying element (706) and the first switch (708) and the second rectifying element (707) has a polarity direction opposite to that of the first rectifying element (706);
a first isolating element (710) having two input terminals and having two output terminals electrically connected to the first switch (708) and the second terminal (702) respectively, wherein upon receipt of the first switching voltage, the first isolating element (710) outputs a first voltage to turn on the first switch (708);
a second isolating element (711) having two input terminals and having two output terminals electrically connected to the second switch (709) and the first terminal (701) respectively, wherein upon receipt of the second switching voltage, the second isolating element (711) outputs a second voltage to turn on the second switch (709), and wherein when the door chime enable terminal (705) receives the door chime enable voltage, the first isolating element (710) and the second isolating element (711) respectively output an enable voltage to simultaneously turn on the first switch (708) and the second switch (709);
a third switch (712) connected in series between a ground terminal and one input terminal of the first isolating element (710), wherein a gate of the third switch (712) is electrically connected to the door chime enable terminal (705);
a fourth switch (713) connected in series between the ground terminal and the one input terminal of the first isolating element (710), wherein a gate of the fourth switch (713) is electrically connected to the first switching terminal (703);
a fifth switch (716) connected in series between the ground terminal and one input terminal of the second isolating element (711), wherein a gate of the fifth switch (716) is electrically connected to the door chime enable terminal (705); and
a sixth switch (717) connected in series between the ground terminal and the one input terminal of the second isolating element (711), wherein a gate of the sixth switch (717) is electrically connected to the second switching terminal (704).

2. The door chime control circuit according to claim 1, wherein the two input terminals of the first isolating element (710) are electrically connected to a voltage source and the third switch (712) and the fourth switch (713) respectively, one of the output terminals of the first isolating element (710) is electrically connected to a gate of the first switch (708), the two input terminals of the second isolating element (711) are electrically connected to the voltage source and the fifth switch (716) and the sixth switch (717) respectively, and one of the output terminals of the second isolating element (711) is electrically connected to a gate of the second switch (709).

3. The door chime control circuit according to claim 2, wherein the first switch (708) is a bipolar junction transistor switch, and the gate of the first switch (708) is a base of the bipolar junction transistor switch.

4. The door chime control circuit according to claim 2, wherein the second switch (709) is a bipolar junction transistor switch, and the gate of the second switch (709) is a base of the bipolar junction transistor switch.

5. The door chime control circuit according to claim 1, wherein the first rectifying element (706) and the second rectifying element (707) are diodes.

6. The door chime control circuit according to claim 1, wherein the first isolating element (710) and the second isolating element (711) are optical couplers.

7. The door chime control circuit according to claim 1, wherein the third switch (712), the fourth switch (713), the fifth switch (716), and the sixth switch (717) are metal oxide semiconductor field effect transistor switches.

8. The door chime control circuit according to claim 1, further comprising:
a first resistor (714) connected in series between the third switch (712) and the one input terminal of the first isolating element (710)
a second resistor (715) connected in series between the fourth switch (713) and the one input terminal of the first isolating element (710);
a third resistor (718) connected in series between the fifth switch (716) and the one input terminal of the second isolating element (711); and
a fourth resistor (719) connected in series between the sixth switch (717) and the one input terminal of the second isolating element (711)

9. The door chime control circuit according to claim 8, wherein a resistance value of the first resistor (714) is less than a resistance value of the second resistor (715), and a resistance value of the third resistor (718) is less than a resistance value of the fourth resistor (719).

## Patentansprüche

1. Eine Türklingelsteuerschaltung (7), die dazu konfiguriert ist, zwischen eine Leistungsversorgung und eine Türklingel geschaltet zu sein, und folgende Merkmale aufweist:
einen ersten Anschluss (701), der dazu konfiguriert ist, mit der Leistungsversorgung verbunden zu sein;
einen zweiten Anschluss (702), der dazu konfiguriert ist, mit der Türklingel verbunden zu sein;
einen ersten Schaltanschluss (703), der dazu konfiguriert ist, eine erste Schaltspannung zu empfangen;
einen zweiten Schaltanschluss (704), der dazu konfiguriert ist, eine zweite Schaltspannung zu empfangen;
einen Türklingelaktivierungsanschluss (705), der dazu konfiguriert ist, eine Türklingelaktivierungsspannung zu empfangen;
ein erstes Gleichrichtungselement (706), das mit dem zweiten Anschluss (702) elektrisch verbunden ist;
ein zweites Gleichrichtungselement (707), das mit dem ersten Anschluss (701) elektrisch verbunden ist;
einen ersten Schalter (708), der zwischen den ersten Anschluss (701) und das erste Gleichrichtungselement (706) und in Serie mit dem ersten Gleichrichtungselement (706) geschaltet ist, wobei die erste Schaltspannung dazu verwendet wird, den ersten Schalter (708) einzuschalten, um das erste Gleichrichtungselement (706) zu aktivieren;
einen zweiten Schalter (709), der zwischen den zweiten Anschluss (702) und das zweite Gleichrichtungselement (707) und in Serie mit dem zweiten Gleichrichtungselement (707) geschaltet ist, wobei die zweite Schaltspannung dazu verwendet wird, den zweiten Schalter (709) einzuschalten, um das zweite Gleichrichtungselement (707) zu aktivieren;
wobei das zweite Gleichrichtungselement (707) und der zweite Schalter (709) parallel mit dem ersten Gleichrichtungselement (706) und dem ersten Schalter (708) geschaltet sind und das zweite Gleichrichtungselement (707) eine Polaritätsrichtung aufweist, die der des ersten Gleichrichtungselements (706) entgegengesetzt ist;
ein erstes Isolationselement (710) mit zwei Eingangsanschlüssen und mit zwei Ausgangsanschlüssen, die jeweils mit dem ersten Schalter (708) und dem zweiten Anschluss (702) elektrisch verbunden sind, wobei das erste Isolationselement (710) bei Empfang der ersten Schaltspannung eine erste Spannung ausgibt, um den ersten Schalter (708) einzuschalten;
ein zweites Isolationselement (711) mit zwei Eingangsanschlüssen und mit zwei Ausgangsanschlüssen, die jeweils mit dem zweiten Schalter (709) und dem ersten Anschluss (701) elektrisch verbunden sind, wobei das zweite Isolationselement (711) bei Empfang der zweiten Schaltspannung eine zweite Spannung ausgibt, um den zweiten Schalter (709) einzuschalten, und wobei, wenn der Türklingelaktivierungsanschluss (705) die Türklingelaktivierungsspannung empfängt, das erste Isolationselement (710) und das zweite Isolationselement (711) jeweils eine Aktivierungsspannung ausgeben, um den ersten Schalter (708) und den zweiten Schalter (709) gleichzeitig einzuschalten;
einen dritten Schalter (712), der in Serie zwischen einen Erdungsanschluss und einen Eingangsanschluss des ersten Isolationselements (710) geschaltet ist, wobei ein Gate des dritten Schalters (712) mit dem Türklingelaktivierungsanschluss (705) elektrisch verbunden ist;
einen vierten Schalter (713), der in Serie zwischen den Erdungsanschluss und den einen Eingangsanschluss des ersten Isolationselements (710) geschaltet ist, wobei ein Gate des vierten Schalters (713) mit dem ersten Schaltanschluss (703) elektrisch verbunden ist;
einen fünften Schalter (716), der in Serie zwischen den Erdungsanschluss und den einen Eingangsanschluss des zweiten Isolationselements (711) geschaltet ist, wobei ein Gate des fünften Schalters (716) mit dem Türklingelaktivierungsanschluss (705) elektrisch verbunden ist; und
einen sechsten Schalter (717), der in Serie zwischen den Erdungsanschluss und den einen Eingangsanschluss des zweiten Isolationselements (711) geschaltet ist, wobei ein Gate des sechsten Schalters (717) mit dem zweiten Schaltanschluss (704) elektrisch verbunden ist.

2. Die Türklingelsteuerschaltung gemäß Anspruch 1, bei der die zwei Eingangsanschlüsse des ersten Isolationselements (710) mit einer Spannungsquelle und dem dritten Schalter (712) bzw. dem vierten Schalter (713) elektrisch verbunden sind, einer der Ausgangsanschlüsse des ersten Isolationselements (710) mit einem Gate des ersten Schalters (708) elektrisch verbunden ist, die zwei Eingangsanschlüsse des zweiten Isolationselements (711) mit der Spannungsquelle und dem fünften Schalter (716) bzw. dem sechsten Schalter (717) elektrisch verbunden sind, und einer der Ausgangsanschlüsse des zweiten Isolationselements (711) mit einem Gate des zweiten Schalters (709) elektrisch verbunden ist.

3. Die Türklingelsteuerschaltung gemäß Anspruch 2, bei der der erste Schalter (708) ein Bipolartransistorschalter ist und das Gate des ersten Schalters (708) eine Basis des Bipolartransistorschalters ist.

4. Die Türklingelsteuerschaltung gemäß Anspruch 2, bei der der zweite Schalter (709) ein Bipolartransistorschalter ist und das Gate des zweiten Schalters (709) eine Basis des Bipolartransistorschalters ist.

5. Die Türklingelsteuerschaltung gemäß Anspruch 1, bei der das erste Gleichrichtungselement (706) und das zweite Gleichrichtungselement (707) Dioden sind.

6. Die Türklingelsteuerschaltung gemäß Anspruch 1, bei der das erste Isolationselement (710) und das zweite Isolationselement (711) Optokoppler sind.

7. Die Türklingelsteuerschaltung gemäß Anspruch 1, bei der der dritte Schalter (712), der vierte Schalter (713), der fünfte Schalter (716) und der sechste Schalter (717) Metall-Oxid-Halbleiter-Feldeffekttransistorschalter sind.

8. Die Türklingelsteuerschaltung gemäß Anspruch 1, die ferner folgende Merkmale aufweist:
einen ersten Widerstand (714), der in Serie zwischen den dritten Schalter (712) und den einen Eingangsanschluss des ersten Isolationselements (710) geschaltet ist;
einen zweiten Widerstand (715), der in Serie zwischen den vierten Schalter (713) und den einen Eingangsanschluss des ersten Isolationselements (710) geschaltet ist;
einen dritten Widerstand (718), der in Serie zwischen den fünften Schalter (716) und den einen Eingangsanschluss des zweiten Isolationselements (711) geschaltet ist; und
einen vierten Widerstand (719), der in Serie zwischen den sechsten Schalter (717) und den einen Eingangsanschluss des zweiten Isolationselements (711) geschaltet ist.

9. Die Türklingelsteuerschaltung gemäß Anspruch 8, bei der ein Widerstandswert des ersten Widerstands (714) geringer ist als ein Widerstandswert des zweiten Widerstands (715) und ein Widerstandswert des dritten Widerstands (718) geringer ist als ein Widerstandswert des vierten Widerstands (719).

## Revendications

1. Circuit de commande de sonnerie de porte (7) configuré pour être connecté entre une alimentation de courant électrique et une sonnerie de porte, comprenant:
une première borne (701) configurée pour être connectée à l'alimentation de courant électrique; une deuxième borne (702) configurée pour être connectée à la sonnerie de porte;
une première borne de commutation (703) configurée pour recevoir une première tension de commutation;
une deuxième borne de commutation (704) configurée pour recevoir une deuxième tension de commutation;
une borne d'activation de sonnerie de porte (705) configurée pour recevoir une tension d'activation de sonnerie de porte;
un premier élément de redressement (706) connecté électriquement à la deuxième borne (702);
un deuxième élément de redressement (707) connecté électriquement à la première borne (701);
un premier commutateur (708) connecté entre la première borne (701) et le premier élément de redressement (706) et en série avec le premier élément de redressement (706), où la première tension de commutation est utilisée pour activer le premier commutateur (708) pour activer le premier élément de redressement (706);
un deuxième commutateur (709) connecté entre la deuxième borne (702) et le deuxième élément de redressement (707) et en série avec le deuxième élément de redressement (707), où la deuxième tension de commutation est utilisée pour activer le deuxième commutateur (709) pour activer le deuxième élément de redressement (707);
dans lequel le deuxième élément de redressement (707) et le deuxième commutateur (709) sont connectés en parallèle avec le premier élément de redressement (706) et le premier commutateur (708), et le deuxième élément de redressement (707) présente une direction de polarité opposée à celle du premier élément de redressement (706);
un premier élément d'isolation (710) présentant deux bornes d'entrée et présentant deux bornes de sortie connectées électriquement respectivement au premier commutateur (708) et à la deuxième borne (702), où, lors de la réception de la première tension de commutation, le premier élément d'isolation (710) sort une première tension pour activer le premier commutateur (708);
un deuxième élément d'isolation (711) présentant deux bornes d'entrée et présentant deux bornes de sortie connectées électriquement respectivement au deuxième commutateur (709) et à la première borne (701), dans lequel, lors de la réception de la deuxième tension de commutation, le deuxième élément d'isolation (711) sort une deuxième tension pour activer le deuxième commutateur (709), et dans lequel, lorsque la borne d'activation de sonnerie de porte (705) reçoit la tension d'activation de sonnerie de porte, le premier élément d'isolation (710) et le deuxième élément d'isolation (711) sortent respectivement une tension d'activation pour activer simultanément le premier commutateur (708) et le deuxième commutateur (709);
un troisième commutateur (712) connecté en série entre une borne de terre et une borne d'entrée du premier élément d'isolation (710), où une grille du troisième commutateur (712) est connectée électriquement à la borne d'activation de sonnerie de porte (705);
un quatrième commutateur (713) connecté en série entre la borne de terre et la borne d'entrée du premier élément d'isolation (710), où une grille du quatrième commutateur (713) est connectée électriquement à la première borne de commutation (703);
un cinquième commutateur (716) connecté en série entre la borne de terre et une borne d'entrée du deuxième élément d'isolation (711), où une grille du cinquième commutateur (716) est connectée électriquement à la borne d'activation de sonnerie de porte (705); et
un sixième commutateur (717) connecté en série entre la borne de terre et la borne d'entrée du deuxième élément d'isolation (711), où une grille du sixième commutateur (717) est connectée électriquement à la deuxième borne de commutation (704).

2. Circuit de commande de sonnerie de porte selon la revendication 1, dans lequel les deux bornes d'entrée du premier élément d'isolation (710) sont connectées électriquement respectivement à une source de tension et au troisième commutateur (712) et au quatrième commutateur (713), l'une des bornes de sortie du premier élément d'isolation (710) est connectée électriquement à une grille du premier commutateur (708), les deux bornes d'entrée du deuxième élément d'isolation (711) sont connectées électriquement respectivement à la source de tension et au cinquième commutateur (716) et au sixième commutateur (717), et l'une des bornes de sortie du deuxième élément d'isolation (711) est connectée électriquement à une grille du deuxième commutateur (709).

3. Circuit de commande de sonnerie de porte selon la revendication 2, dans lequel le premier commutateur (708) est un commutateur à transistor à jonction bipolaire, et la grille du premier commutateur (708) est une base du commutateur à transistor à jonction bipolaire.

4. Circuit de commande de sonnerie de porte selon la revendication 2, dans lequel le deuxième commutateur (709) est un commutateur à transistor à jonction bipolaire, et la grille du deuxième commutateur (709) est une base du commutateur à transistor à jonction bipolaire.

5. Circuit de commande de sonnerie de porte selon la revendication 1, dans lequel le premier élément de redressement (706) et le deuxième élément de redressement (707) sont des diodes.

6. Circuit de commande de sonnerie de porte selon la revendication 1, dans lequel le premier élément d'isolation (710) et le deuxième élément d'isolation (711) sont des coupleurs optiques.

7. Circuit de commande de sonnerie de porte selon la revendication 1, dans lequel le troisième commutateur (712), le quatrième commutateur (713), le cinquième commutateur (716) et le sixième commutateur (717) sont des commutateurs à transistor à effet de champ à semi-conducteur à base d'oxyde métallique.

8. Circuit de commande de sonnerie de porte selon la revendication 1, comprenant par ailleurs:
une première résistance (714) connectée en série entre le troisième commutateur (712) et l'une borne d'entrée du premier élément d'isolation (710);
une deuxième résistance (715) connectée en série entre le quatrième commutateur (713) et l'une borne d'entrée du premier élément d'isolation (710);
une troisième résistance (718) connectée en série entre le cinquième commutateur (716) et l'une borne d'entrée du deuxième élément d'isolation (711); et
une quatrième résistance (719) connectée en série entre le sixième commutateur (717) et l'une borne d'entrée du deuxième élément d'isolation (711).

9. Circuit de commande de sonnerie de porte selon la revendication 8, dans lequel une valeur de résistance de la première résistance (714) est inférieure à une valeur de résistance de la deuxième résistance (715), et une valeur de résistance de la troisième résistance (718) est inférieure à une valeur de résistance de la quatrième résistance (719).
